# EUROPEAN PATENT APPLICATION

(11) **EP 3 448 079 A1**
(43) Date of publication of application: **27.02.2019**
(21) Application number: 18189921.2
(22) Date of filing: 21.08.2018
(51) Int. Cl.: H04W 16/18, H04W 4/02

(54) **SYSTEMS AND METHODS FOR VERIFYING ACCEPTABLE PERFORMANCE OF A NETWORK IN A BUILDING**

(30) Priority: 21.08.2017 US 201762548039 P
(71) Applicant: PC-Tel, Inc., Bloomingdale, IL 60108 (US)
(72) Inventor: ADAMS, David E, Bloomingdale, IL Illinois 60108 (US); FOO, SeatQuen, Bloomingdale, IL Illinois 60108 (US); KORI, Poornima, Bloomingdale, IL Illinois 60108 (US)
(74) Representative: Haseltine Lake LLP

(57) **Abstract**

Systems and methods for verifying acceptable performance of a wireless network in a region being tested are provided and can include an electronic device identifying a test location within the region, the electronic device guiding a user to the test location based on comparing a first GPS coordinate of the test location and a second GPS coordinate of the electronic device, and the electronic device automatically scanning the wireless network to capture quality parameters of a connection on the wireless network when the second GPS coordinate substantially matches the first GPS coordinate.

## Description

### CROSS-REFERENCE TO RELATED APPLICATIONS

This application claims priority to U.S. Provisional Patent Application No. 62/548,039 filed August 21, 2017 and titled "SYSTEMS AND METHODS FOR VERIFYING ACCEPTABLE PERFORMANCE OF A PUBLIC SAFETY NETWORK IN A BUILDING." U.S. Provisional Patent Application No. 62/548,039 is hereby incorporated herein by reference.

### FIELD

The present invention relates generally to wireless communication network performance. More particularly, the present invention relates to systems and methods for verifying acceptable performance of a public safety network in a building.

### BACKGROUND

Before providing approval to occupy buildings, such as renovated buildings or existing buildings, governing jurisdictions, such as city and county agencies, are increasingly adopting, with some modifications, guidelines from national organizations, such as the National Fire Protection Association (NFPA) and the International Fire Code (IFC), and requiring building owners to measure indoor coverage provided by outdoor public safety networks, such as networks that employ P25 and TETRA technologies (and, soon, LTE technologies for FirstNet in the United States). Furthermore, governing jurisdictions are requiring building owners to report on success based on specific criteria, such as grid-based testing. However, progress in implementing such requirements is impeded by the lack of network measurement tools to perform such measuring and reporting in a cost effective manner.

For example, known systems and methods for meeting such guidelines include a user manually taking measurements of a test site, manually recording such measurements, and manually transferring the measurements into a hand crafted report. Specifically, the user acquires a floor plan of the test site, manually draws a grid on the floor plan, and manually annotates the grid for test points (e.g., one test point per grid area), critical points (e.g., stairs), reference points (e.g. outside of the test site where a signal is strongest), and points not tested (e.g., inaccessible areas). Then, the user accesses measurement equipment to measure the downlink power of signals received from the outdoor public safety networks or accesses a hand held radio to place voice calls and measure a voice quality of the voice calls. In some cases, the uplink power is also measured. In other cases, a signal quality is measured using signal-to-noise (SNR) or bit error rate (BER) measurements. After testing, the user manually annotates the grid with such measurements, and often, two users are required to execute such methods: one person to take the measurements and one person to guide the users and record the measurements. After testing, the user manually transfers all of the measurements to the hand crafted report, which the user manually updates with results of manual calculations performed to determine a pass/fail result for each grid area, each critical point, and the test site as a whole using a predetermined threshold.

The above-identified systems and methods are prone to user errors, and both the measuring and the reporting require a lot of time and effort, making them cost prohibitive. Therefore, governing jurisdictions are more likely to refrain from adopting or enforcing the requirement for building owners to measure the indoor coverage provided by the outdoor public safety networks and report on the success thereof.

Some systems and methods have been developed to automate the above-identified systems and methods. However, known automated systems and methods do not use a map with grid-based testing. Furthermore, known automated systems and methods are either phone-based, which are handheld, integrated in a hardware box, provide no LTE support, have low accuracy, and are provided by external vendors, or include a single analyzer, which are expensive and cumbersome.

In view of the above, there is a continuing, ongoing need for improved systems and methods.

### BRIEF DESCRIPTION OF THE DRAWINGS

FIG. 1 is a block diagram of a system in accordance with disclosed embodiments;
FIG. 2 is a flow diagram of a method in accordance with disclosed embodiments;
FIG. 3 is a flow diagram of a method in accordance with disclosed embodiments;
FIG. 4 is a screen shot of a user interface generated by systems and methods in accordance with disclosed embodiments;
FIG. 5 is a screen shot of a user interface generated by systems and methods in accordance with disclosed embodiments;
FIG. 6 is a screen shot of a user interface generated by systems and methods in accordance with disclosed embodiments;
FIG. 7 is a screen shot of a user interface generated by systems and methods in accordance with disclosed embodiments;
FIG. 8 is a screen shot of a user interface generated by systems and methods in accordance with disclosed embodiments; and
FIG. 9 is a screen shot of a user interface generated by systems and methods in accordance with disclosed embodiments.

### DETAILED DESCRIPTION

While this invention is susceptible of an embodiment in many different forms, there are shown in the drawings and will be described herein in detail specific embodiments thereof with the understanding that the present disclosure is to be considered as an exemplification of the principles of the invention. It is not intended to limit the invention to the specific illustrated embodiments.

Embodiments disclosed herein can include systems and methods for verifying acceptable performance of a public safety network in a building. Accordingly, systems and methods disclosed herein can confirm whether first responders to the building have reliable radio performance and intelligible voice communications everywhere they are needed within the building. Advantageously, systems and methods disclosed herein can automate previously known manual systems and methods to measure indoor coverage provided by outdoor public safety networks and report on the success thereof, thereby improving accuracy and reducing measurement and reporting time by up to approximately 80%.

In accordance with disclosed embodiments, systems and methods disclosed herein can automatically import a floor plan of a test site, automatically create a grid on the floor plan, automatically annotate the grid for test points (e.g., one test point per grid area), critical points (e.g., stairs), reference points (e.g. outside of the test site where a signal is strongest), and points not tested (e.g., inaccessible areas), and automatically import test criteria, for example, predetermined or user configurable test criteria. Then, systems and methods disclosed herein can automatically provide guidance to a user to move to locations for taking measurements, can automatically execute the measurements for the different locations, can automatically record the measurements, can automatically grade performance (pass/fail) based on the measurements and the test criteria, and can automatically generate a report based thereon. Accordingly, systems and methods disclosed herein can be fully integrated and executed by a single software application that is executed on a single electronic device, such as a smartphone, a laptop, or a tablet.

In some embodiments, systems and methods disclosed herein can measure the downlink power or the uplink power of signals received from or transmitted to the outdoor public safety networks, for example, using SNR or BER measurements. Additionally or alternatively, in some embodiments systems and methods disclosed herein can measure the voice quality of voice calls without placing a manual voice call.

As explained above, systems and methods disclosed herein can automatically create the grid on the floor plan of the test site. In this regard and in some embodiments, systems and methods disclosed herein can create the grid on any map as would be understood by one of ordinary skill in the art. Additionally or alternatively, in some embodiments, systems and methods disclosed herein can receive user input to create or edit the grid, for example, user input to select the number of areas on the grid, user input to change the number of areas on the grid, user input to reset the measurements identified on the grid, user input to adjust a color of an outline on the grid, user input to identify selected ones of the areas on the grid as unused, or user input to color-code the selected ones of the areas accordingly to omit the selected ones of the areas in counts and measurements. Additionally or alternatively, in some embodiments, the grid can be adjustable to fit the floor plan. Additionally or alternatively, in some embodiments, the grid can be saved with the floor plan, and in some embodiments, the grid can be exported. Additionally or alternatively, in some embodiments, systems and methods disclosed herein can automatically calculate and display a number and sizes of the areas on the grid, a size of the grid as a whole, and a relative size of largest ones of the areas to smallest ones of the areas on the grid. Additionally or alternatively, in some embodiments, systems and methods disclosed herein can automatically create multiple grids on the floor plan of the test site.

As explained above, systems and methods disclosed herein can automatically annotate the grid for the test points, the critical points, the reference points, and the points not tested, can automatically import the test criteria, can automatically provide the guidance to the user to move to the locations for taking the measurements, can automatically execute the measurements for the different locations, and can automatically record the measurements. In this regard and in some embodiments, systems and methods disclosed herein can receive user input to place a test icon in the selected ones of the areas of the grid, including outside of external walls of the test site, receive user input to move test icons on the grid, receive user input that includes commentary related to the test icons on the grid, or receive user input to start a test for the selected ones of the areas of the grid, to display real time values of the measurements, or to capture and display maximum or average values of the measurements. Additionally or alternatively, in some embodiments, systems and methods disclosed herein can automatically and electronically generate a value for or receive user input that includes the value for a voice test, for example, when the voice test that was manually or electronically placed, and can record the value for the voice test with respect to a GPS location on the floor plan or the grid from where a voice call was placed.

As explained above, systems and methods disclosed herein can automatically grade the performance based on the measurements and the test criteria. In this regard and in some embodiments, systems and methods disclosed herein can grade one of the areas on the grid with a pass grade when the downlink power of the signals received from the outdoor public safety networks is greater than a predetermined threshold and, when applicable, the value of the voice test executed in that area passes. Additionally or alternatively, in some embodiments, systems and methods disclosed herein can grade the grid with the pass grade when a number of the areas with the pass grade is greater than a predetermined threshold percentage. Additionally or alternatively, in some embodiments, systems and methods disclosed herein can grade a floor of the test site with the pass grade when the number of the areas on the floor with the pass grade is greater than the predetermined threshold percentage and a number of the critical points on the floor with the pass grade is greater than a predetermined critical point percentage. Additionally or alternatively, in some embodiments, systems and methods disclosed herein can grade the test site with the pass grade when the number of the areas in the test site with the pass grade is greater than the predetermined threshold percentage and the number of the critical points in the test site is greater than the predetermined critical point percentage. Additionally or alternatively, in some embodiments, systems and methods disclosed herein can grade the test site with the pass grade when all channels tested for the test site receive the pass grade. Additionally or alternatively, in some embodiments, systems and methods disclosed herein can display one or more colors on the grid or the floor plan representative of assigned grades or the measurements.

As explained above, systems and methods disclosed herein can automatically generate the report. In this regard and in some embodiments, systems and methods disclosed herein can generate the report for each floor of the test site, and in some embodiments, the report for each floor of the test site can include some or all of a result (pass, fail, blank), channel information, the number and a percentage of the areas tested, the number and the percentage of the areas passing, the number and the percentage of the critical points tested, the number and the percentage of the critical points passing, a pass criteria area, and pass criteria critical points. Additionally or alternatively, in some embodiments, systems and methods disclosed herein can generate the report for the test site as a whole, and in some embodiments, the report for the test site as a whole can include some or all of the result (pass - the grade is pass when all channels receive the pass grade, fail, blank), the number of floors tested, a table illustrating the number of pass grades for each channel tested and the number of fail grades for each channel tested, the number and the percentage of the areas tested, the number and the percentage of the areas passing, the number and the percentage of the critical points tested, the number and the percentage of the critical points passing, the pass criteria area, and the pass criteria critical points. Additionally or alternatively, in some embodiments, the report can include a user interface device that can receive user input to change the channels tested, edit the pass criteria area, or edit the pass criteria critical points.

As explained above, systems and method disclosed herein can provide guidance to the user to move to the locations for taking the measurements. For example, systems and methods disclosed herein can use GPS data from an electronic device carried by the user to determine whether the user is at or substantially near (e.g. within a predetermined distance of, such as 3 feet) a test location. Then, systems and methods disclosed herein can display a distance (e.g. a number of feet) and a direction (e.g. northwest or 10 o'clock) to the test location or can provide turn-by-turn navigation to the test location based on the floor plan for the building stored in a memory device. Responsive to the user moving to the test location and systems and methods disclosed herein determining that the user and the electronic device are at or substantially near the test location (e.g. by comparing GPS coordinates of the test location and GPS coordinates of the electronic device's location), systems and methods disclosed herein can automatically begin testing the performance of the outdoor public safety network in the building. For example, responsive to determining that the user and the electronic device are at or substantially near the test location, systems and methods disclosed herein can instruct a scanner to collect the measurements or parameters of a voice call between the scanner and another radio. Responsive thereto, the scanner can provide the measurements or the parameters of the voice call to the electronic device, and the electronic device can store the measurements or the parameters.

In some embodiments, the electronic device can detect whether the user is walking up or down a set of stairs and changing floors within the building by analyzing signals received from a gyroscope of the electronic device (e.g. a smart watch that includes a gyroscope). For example, responsive to comparing current gyroscope readings to pre-stored gyroscope readings indicative of the user walking up or down a set of stairs, systems and methods disclosed herein can determine whether the user is walking up or down a set of stairs and, therefore, that the user is changing floors within the building. In some embodiments, responsive to determining that the user is changing floors, systems and methods disclosed herein can change the floor plan displayed on a screen of the electronic device from the floor plan for one floor to the floor plan for a new floor and identify the test location to which the user should move next on the new floor.

Systems and methods disclosed herein are described in connection with grid-based testing. However, it is to be understood that embodiments disclosed herein are not so limited and can include path-based testing in which the scanner continuously captures the measurements or the parameters of the voice call on the outdoor public safety while the user walks along a predetermined path through the building. In some embodiments, the electronic device can instruct the user to pause for a predetermined period of time (e.g. 3-5 seconds) at identified locations, but the voice call despite the user pausing. In some embodiments, the voice call can include a prerecorded message playing on a loop or a live conversation between two human users.

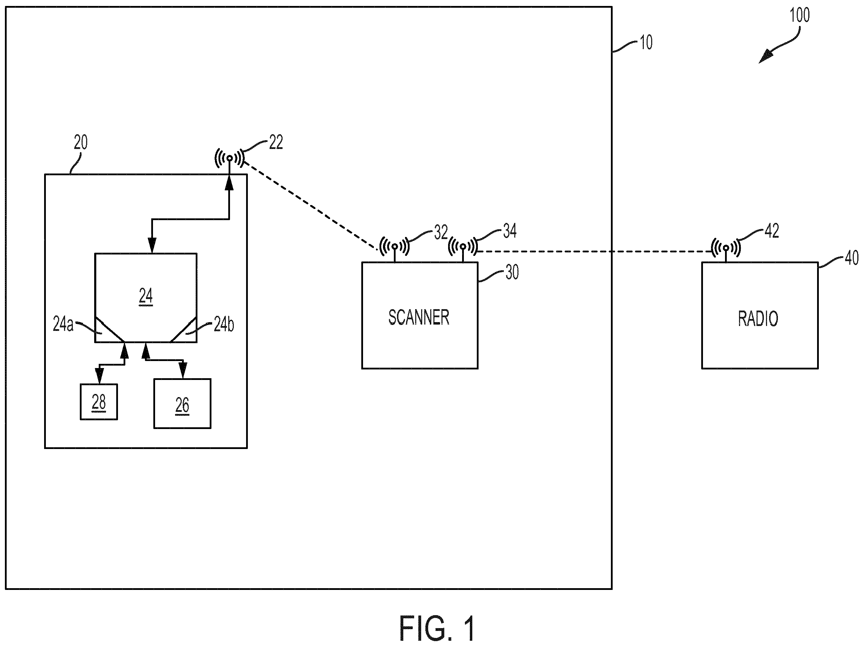

FIG. 1 is a block diagram of a system 100 in accordance with disclosed embodiments. As shown in FIG. 1, the system 100 can include an electronic device 20, a scanner 30, and a radio 40. The electronic device 20 and the scanner 30 can be located within a building 10 or other area to be tested, and the radio 40 can be located outside of the building 10 or remotely from the building 10.

In some embodiments, the electronic device 20 can communicate with the scanner 30 via a wired or wireless connection. For example, in some embodiments, the electronic device 20 can include a Bluetooth transceiver 22, and the scanner 30 can include a Bluetooth transceiver 32 so that the electronic device 20 can communicate with the scanner via a Bluetooth connection. However, embodiments disclosed herein are not so limited. Instead, the electronic device 20 and the scanner 30 can communicate via any known communication protocol, such as Zigbee, WiFi, NFC, or the like.

In some embodiments, the scanner 30 can also include a second transceiver 34 that can communicate via a public safety network, such as P25 or TETRA. In some embodiments, the second transceiver 34 can receive wireless signals from the radio 40, such as during a voice call between the scanner 30 and the radio 40. However, in some embodiments, a second radio in the building 10 can communicate with the radio 40 during the voice call via the public safety network, and the scanner 30 can gather measurements for voice call quality between the second radio and the radio 40. As shown in FIG. 1, the radio 40 can also include a transceiver 42 that can communicate via the public safety network.

In some embodiments, the electronic device 20 can include control circuitry 24, which can include one or more programmable processors 24a and executable control software 24b as would be understood by one of ordinary skill in the art. The executable control software 24b can be stored on a transitory or non-transitory computer readable medium, including, but not limited to local computer memory, RAM, optical storage media, magnetic storage media, and the like. In some embodiments, the control circuitry 24, the programmable processors 24a, and the executable control software 24b can execute and control some of the methods disclosed herein.

In some embodiments, the control circuitry 24 can communicate with a gyroscope 28 of the electronic device 20 and a GPS module 26 of the electronic device 20 that can receive GPS coordinates of the electronic device 20. For example, the control circuitry 32 can use signals received from the GPS module 26 and the gyroscope 28 to determine whether the electronic device 20 is at or substantially near a testing location in the building 10 or whether a user is walking up or down a set of stairs, thereby identifying a floor within the building 10 on which the electronic device 20 is located.

Although FIG. 1 illustrates the scanner 30 and the electronic device 20 as separate devices, it is to be understood that the scanner 30 and the electronic device 20 can part of a single device. For example, the scanner 30 can include also control circuitry that can execute and control some of the methods disclosed herein. Furthermore, although systems and methods disclosed herein describe the scanner 30 as testing network parameters of the public safety network, the scanner 30 can also be configured to test network quality parameters of other wireless networks (e.g. cellular networks, WiFi networks, etc.)

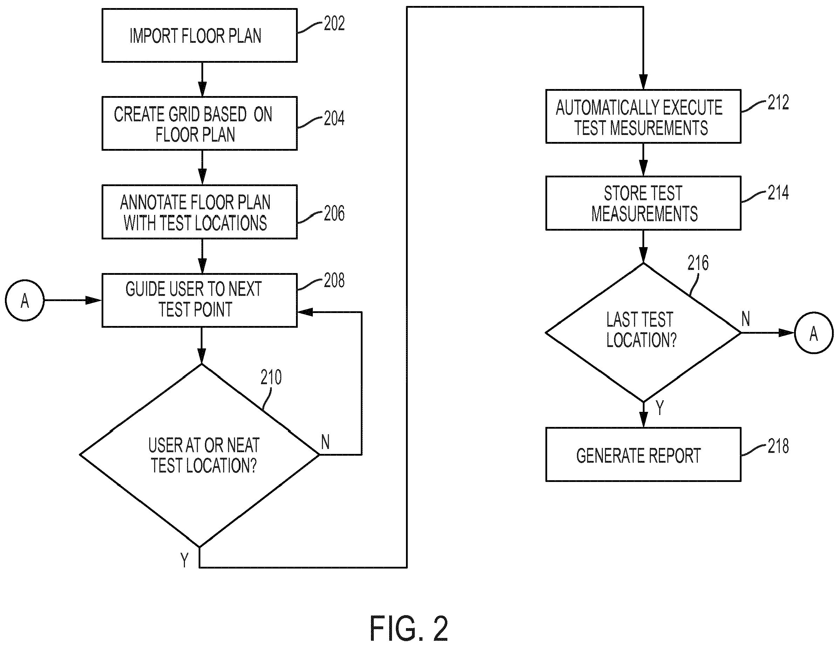

FIG. 2 is a flow diagram of a method 200 in accordance with disclosed embodiments. As shown in FIG. 2, the method 200 can include an electronic device (e.g. the electronic device 20) importing a floor plan as in 202, creating a grid based on the floor plan as in 204, and annotating the floor plan with test locations as in 206. For example, in some embodiments, the electronic device can create the grid responsive to receiving user input identifying a number of the test locations and generating the grid to have a number of areas that matches the number of test locations. Additionally or alternatively, in some embodiments, the electronic device can annotate the grid with the test locations identified via a predetermined algorithm or the user input. For example, the electronic device can identify the test locations at centers of each of the areas of the grid or based on locations of walls identified on the floor plan (e.g. at least 3 feet away from all of the walls).

As shown in FIG. 2, the method 200 can also include the electronic device guiding the user to a test location as in 208 and determining whether the user is at or near the test location as in 210. If the user is not at or near the test location, the electronic device can continue guiding the user to the test location as in 208. However, when the method 200 determines that the user is at or near the test location, the electronic device can automatically instruct a scanner (e.g. the scanner 30) to measure parameters of a network connection as in 212. For example, in some embodiments, the parameters measured can include uplink parameters, and in some embodiments, the network connection can include a voice call with a radio (e.g. the radio 40). In some embodiments, the electronic device can automatically transmit an instruction signal to the scanner to measure the parameters responsive to determining that the GPS coordinates of the electronic device are substantially similar to GPS coordinates for the test location. Additionally or alternatively, in some embodiments, the electronic device can automatically transmit the instruction signal to the scanner or another device, such as the radio, to transmit or begin playback of a voice recording (e.g. 3-5 seconds of voice) responsive to determining that the GPS coordinates of the electronic device are substantially similar to the GPS coordinates for the test location' or responsive to the electronic device instructing the scanner to measure the parameters of the voice call. After receiving the parameters measured by the scanner, the electronic device can store the parameters test measurements as in 214.

As shown in FIG. 2, the method 200 can also include the electronic device determining whether all of the test locations have been tested as in 216. If not, then the method 200 can continue guiding the user to the next test location as in 208. However, when the method 200 determines that all of the test locations have been tested as in 216, the method can include the electronic device generating a report as in 218.

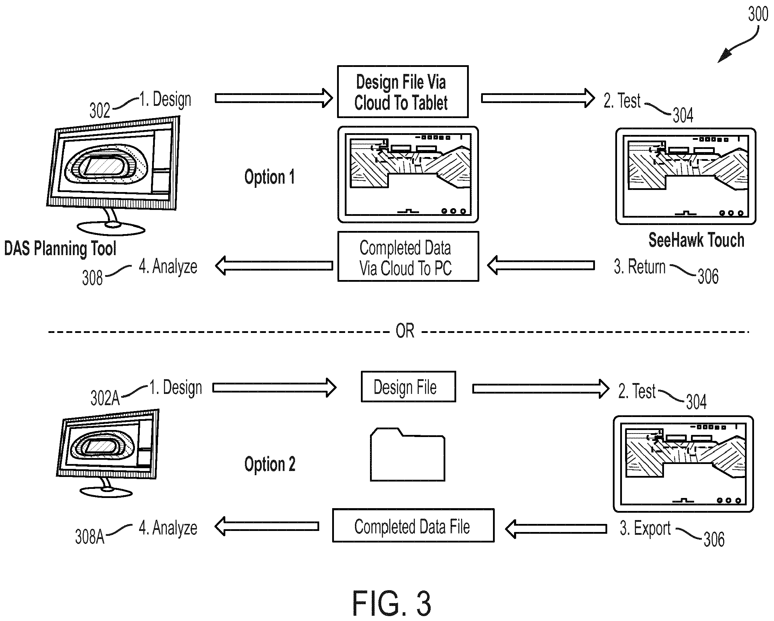

FIG. 3 is a flow diagram of a method 300 in accordance with disclosed embodiments. As shown in FIG 3, the method 300 can include receiving user input to design a floor plan by communicating with a cloud-based design application stored in a server as in 302 or locally as 302A. After designing the floor plan as in 302 or 302A, the method 300 can include an electronic device downloading and importing the floor plan and testing a site according to the method 200 as in step 304. After testing as in 304, the method 300 can include the electronic device transmitting testing results to the server or locally exporting the testing results as in 306, and the server analyzing the testing data to generate a report as in step 308 or the electronic device locally analyzing the testing data to generate the report as in 308A.

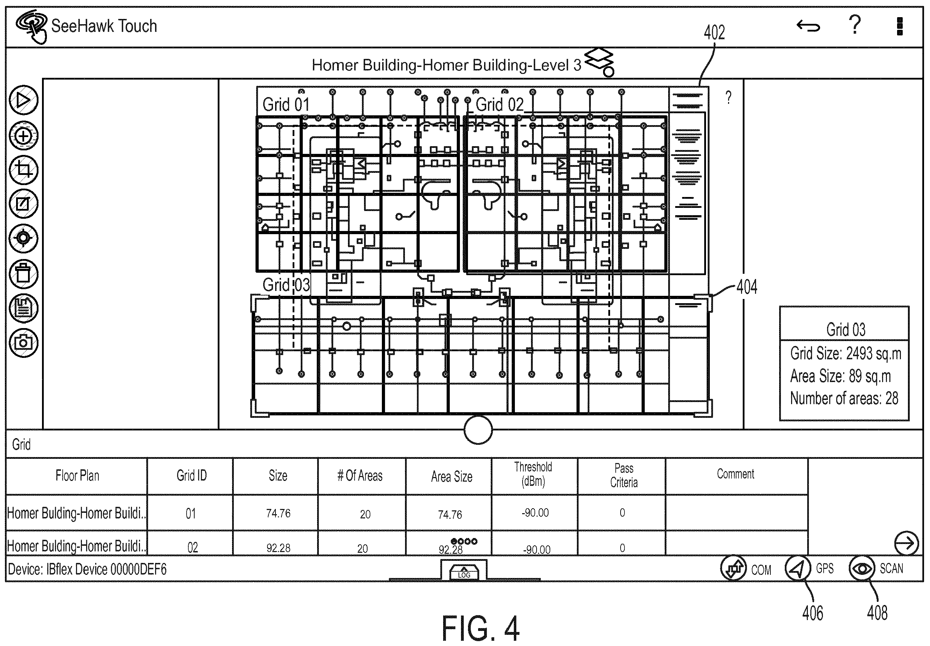

FIG. 4 is a screen shot of a user interface generated by systems and methods disclosed herein that can be displayed on a screen of an electronic device. As shown in FIG. 4, the user interface can include a rendering of a floor plan 402 and a grid 404 overlaying the floor plan 402. In some embodiments, each of a plurality of grids can overlay a respective floor of the floor plan, and in some embodiments, the user interface can resize the grid optimize a display of testing locations on the floor plan.

As also shown in FIG, 4, the user interface can include a GPS button 406 and a scan button 408. In some embodiments, responsive to user input selecting the GPS button 406, the electronic device can identify GPS coordinates of the electronic device and guide a user to a testing location within each area of the grid 404. In some embodiments, the electronic device can identify when the user is at or substantially near the testing location and, responsive thereto and/or responsive receiving user input selecting the scan button 408, can instruct a scanner to scan and test network parameters for a plurality of channels of a wireless network.

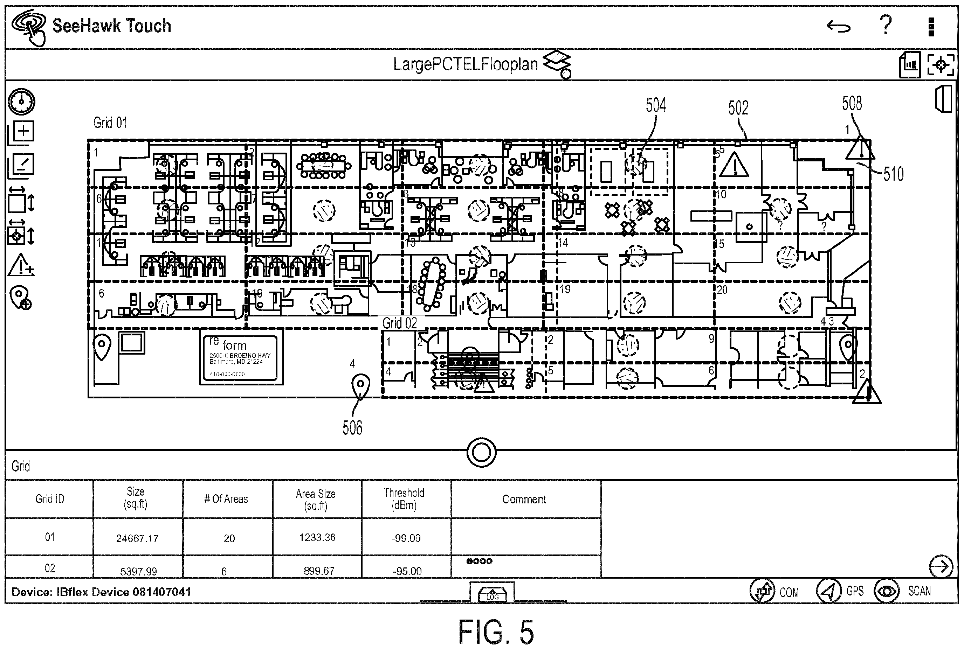

FIG. 5 is a screen shot of a user interface generated by systems and methods disclosed herein that can be displayed on a screen of an electronic device. As shown in FIG. 5, the user interface can include a grid 502, test points 504 (represented by circles), reference points 506 (represented by pins), and "do not test" points 508 (represented by warning signs). In some embodiments, if an area of the grid 502 area does not include any test points 504 or includes only "do not test" points 508, then that area of the grid 502 can be displayed in a color that is different than a display color for a remainder of the grid 502 (e.g. grayed out).

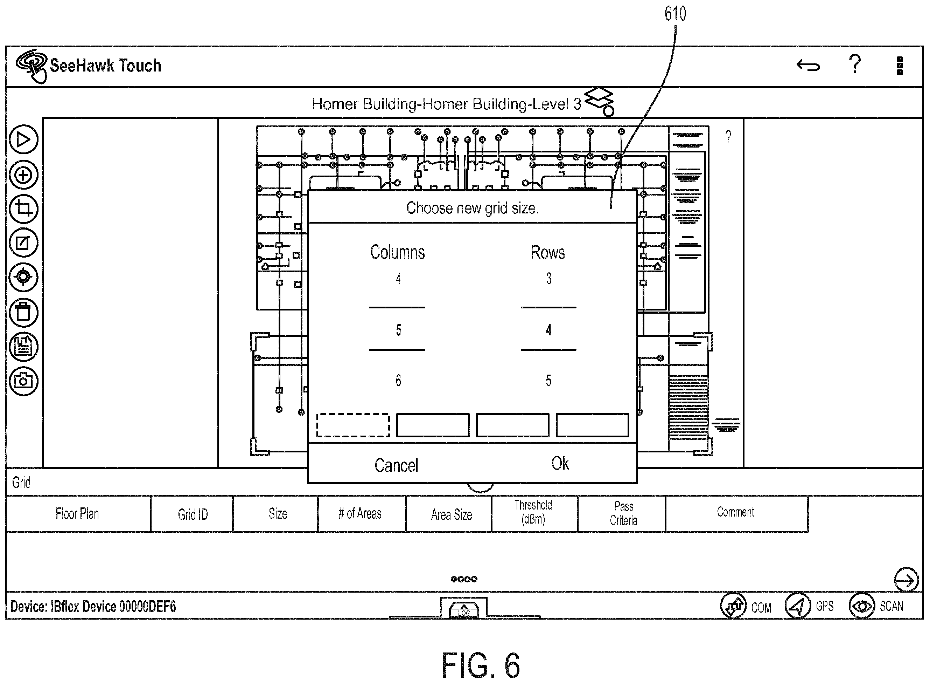

FIG. 6 is a screen shot of a user interface generated by systems and methods disclosed herein that can be displayed on a screen of an electronic device. As shown in FIG. 6, the user interface can include a window 610 that can receive user input to identify a number of columns and a number of rows within a grid to be displayed. However in some embodiments, the electronic device can analyze a floor plan to automatically identify the number of columns and the number of rows for the grid.

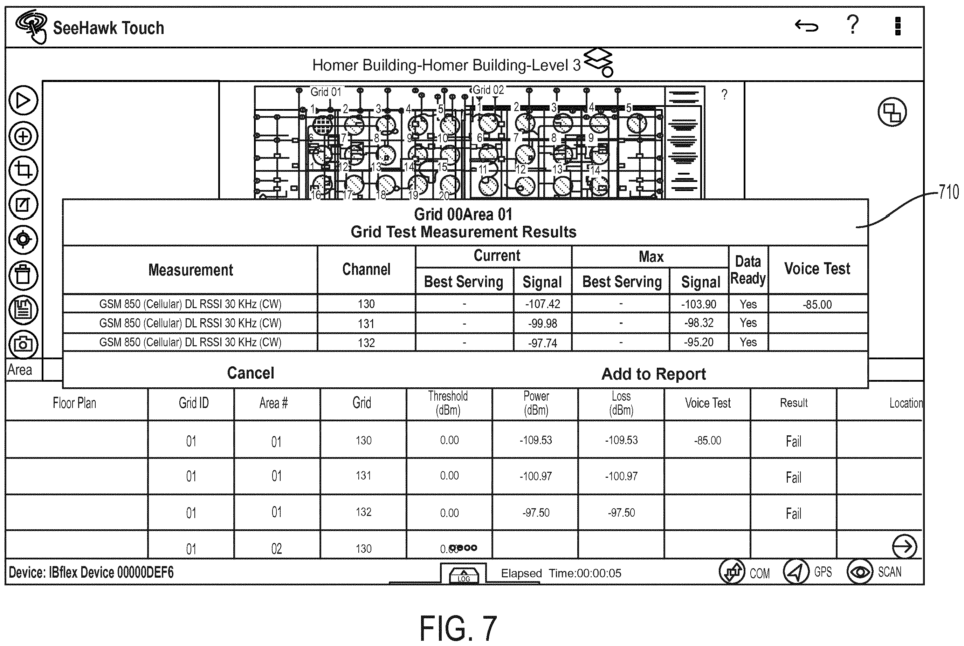

FIG. 7 is a screen shot of a user interface generated by systems and methods disclosed herein that can be displayed on a screen of an electronic device. As shown in FIG. 7, the user interface can include a window 710 that can display the results of an executed test, such signal values for all tested channels.

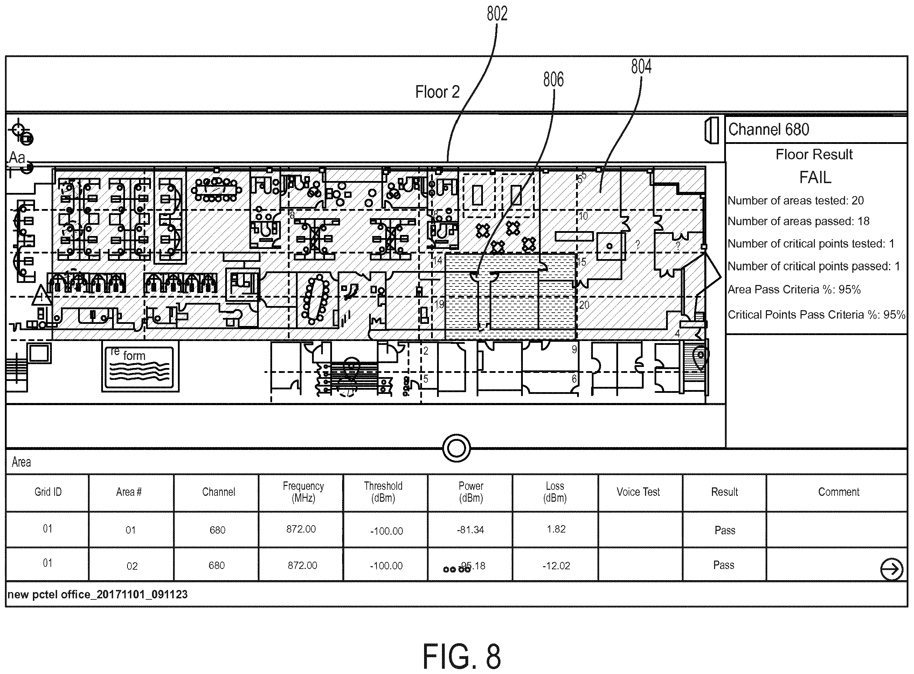

FIG. 8 is a screen shot of a user interface generated by systems and methods disclosed herein that can be displayed on a screen of an electronic device. As shown in FIG. 8, the user interface can include a grid 802 visually depicting testing results using color. For example, passing areas in a test site, such as area 804, can be displayed in green, and failing areas in the test site, such as area 806, can be displayed in red. In some embodiments, the user interface can display floor wide results, such as how many areas on a floor passed, how many areas on the floor were tested, how many critical points of the floor were tested, how many of the critical points of the floor passed, and passing percentages, and in some embodiments, the user interface can be updated after each of the areas is tested.

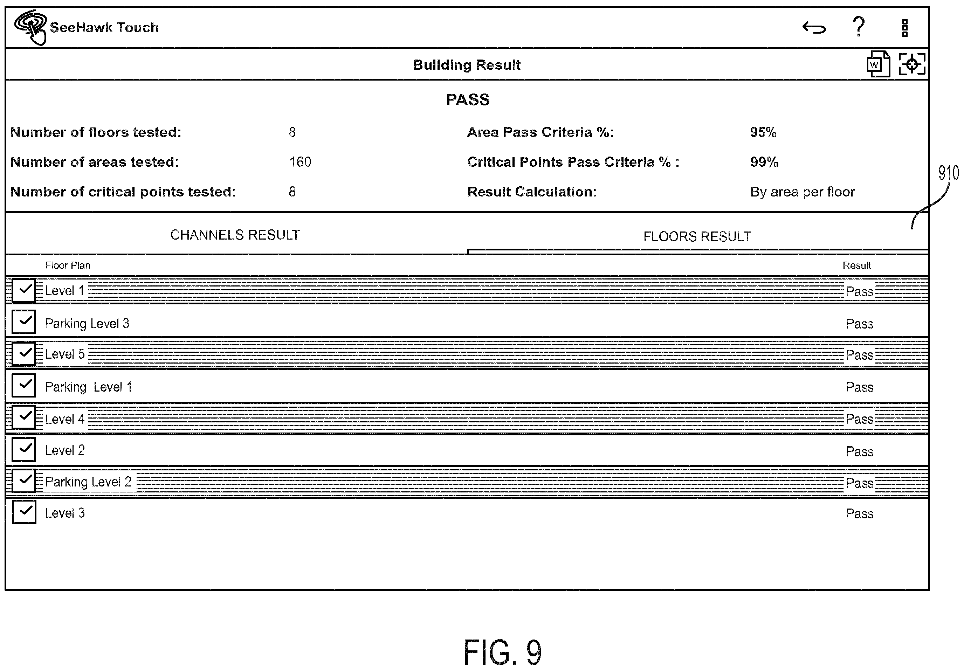

FIG. 9 is a screen shot of a user interface generated by systems and methods disclosed herein that can be displayed on a screen of an electronic device. As shown in FIG. 9, the user interface can include a report 910 that can display how many floors in a test site were tested, how many areas in the test site were tested, how many critical points in the test site were tested, how many critical points in the test site passed, a percentage of the critical points in the test site that passed, a percentage of the areas in the test site that passed, and a floor-by-floor pass or fail grade (e.g. a passing grade can represented by a check mark).

Systems and methods described herein solve a major problem of the prior art - namely, that public safety networks could not be tested efficiently. However, systems and methods disclosed herein not only automate manual tasks, but improve the functioning of existing testing equipment. For example, existing testing equipment, such as scanners, could not previously communicate with other devices or report data to anything other than a human. However, because the electronic device disclosed herein can control the scanner disclosed herein, the scanner can capture measurements and complete tests faster and immediately report and save test data via communication with the electronic device. This is a significant technical improvement over the prior art. Furthermore, existing testing equipment was previously highly susceptible to user error, such as identifying a test location. However, because the electronic device disclosed herein includes a GPS and uses GPS coordinates to identify when and where to test a public safety network test, systems and methods can reduce the amount of user input required, thereby reducing error and allowing for either path-based testing or grid-based testing.

Although a few embodiments have been described in detail above, other modifications are possible. For example, the steps described above do not require the particular order described or sequential order to achieve desirable results. Other steps may be provided, steps may be eliminated from the described flows, and other components may be added to or removed from the described systems. Other embodiments may be within the scope of the invention.

From the foregoing, it will be observed that numerous variations and modifications may be effected without departing from the spirit and scope of the invention. It is to be understood that no limitation with respect to the specific system or method described herein is intended or should be inferred. It is, of course, intended to cover all such modifications as fall within the spirit and scope of the invention.

## Claims

1. A method performed by an electronic device comprising:
identifying a test location within a region being tested;
guiding a user to the test location by comparing a first GPS coordinate of the test location and a second GPS coordinate of the electronic device; and
automatically scanning a wireless network to capture quality parameters of a connection on the wireless network when the second GPS coordinate substantially matches the first GPS coordinate.

2. The method of claim 1 wherein identifying the test location within the region being tested comprises:
importing a floor plan of the region being tested;
creating a grid based on the floor plan; and
annotating the grid to identify the test location.

3. The method of claim 2 wherein annotating the grid comprises:
identifying a critical point and a reference point on the floor plan; and
identifying not-to-be tested points on the floor plan.

4. The method of claim 1, 2 or 3 wherein the connection comprises a voice call on the wireless network, and wherein the quality parameters comprise a signal-to-noise ratio or a bit error rate parameter.

5. The method of any preceding claim wherein guiding the user to the test location comprises identifying a direction to the test location and a distance to the test location.

6. The method of any preceding claim further comprising:
grading the quality parameters to determine whether the test location passes or fails by determining whether the quality parameters exceed a threshold; and
generating a report identifying a grade for the test location.

7. The method of any preceding claim further comprising:
receiving current signals from a gyroscope;
determining whether the current signals from the gyroscope indicate that the electronic device has traveled up or down a set of stairs by comparing the current signals from the gyroscope with predetermined gyroscope signals indicative of stairs.

8. A system comprising:
a scanner configured to capture quality parameters of a connection on a wireless network; and
an electronic device comprising:
a GPS module;
a processor configured to identify a test location within a region being tested, compare a first GPS coordinate of the test location and a second GPS coordinate of the electronic device received from the GPS module, generate directions to the test location based on comparing the first GPS coordinate and the second GPS coordinate, and automatically instruct the scanner to scan the wireless network when the second GPS coordinate substantially matches the first GPS coordinate; and
a user interface configured to display the directions to the test location.

9. The system of claim 8 wherein the processor is further configured to import a floor plan of the region being tested, create a grid based on the floor plan, and annotate the grid to identify the test location.

10. The system of claim 9 wherein the processor is further configured to identify a critical point and a reference point on the floor plan and identify not-to-be tested points on the floor plan.

11. The system of claim 8, 9 or 10 wherein the connection comprises a voice call on the wireless network, and wherein the quality parameters comprise a signal-to-noise ratio or a bit error rate parameter.

12. The system of claim any one of claims 8 to 11 wherein the directions comprise a direction to the test location and a distance to the test location.

13. The system of any of claims 8 to 12 wherein the processor is further configured to grade the quality parameters to determine whether the test location passes or fails by determining whether the quality parameters exceed a threshold and to generate a report identifying a grade for the test location.

14. The system of any one of claims 8 to 13 wherein the processor is further configured to receive current signals from a gyroscope and determine whether the current signals from the gyroscope indicate that the electronic device has traveled up or down a set of stairs by comparing the current signals from the gyroscope with predetermined gyroscope signals indicative of stairs.

15. The method of any one of claims 1 to 7 or the system of any one of claims 8 to 14 wherein the wireless network is a public safety network.
